# EUROPEAN PATENT APPLICATION

(11) **EP 4 184 573 A1**
(43) Date of publication of application: **24.05.2023**
(21) Application number: 20948470.8
(22) Date of filing: 04.08.2020
(51) Int. Cl.: H01L 23/538, H01L 21/00

(54) **MULTICHIP STACKED PACKAGE, ELECTRONIC DEVICE, AND MANUFACTURING METHOD**

(71) Applicant: Huawei Technologies Co., Ltd., Shenzhen, Guangdong 518129 (CN)
(72) Inventor: ZHANG, Liping, Shenzhen, Guangdong 518129 (CN); WANG, Junyou, Shenzhen, Guangdong 518129 (CN); ZHANG, Yanping, Shenzhen, Guangdong 518129 (CN); CUI, Xiaojuan, Shenzhen, Guangdong 518129 (CN); WEI, Xiaoyun, Shenzhen, Guangdong 518129 (CN); YANG, Yong, Shenzhen, Guangdong 518129 (CN); DENG, Chaojun, Shenzhen, Guangdong 518129 (CN)
(74) Representative: Epping - Hermann - Fischer
(86) International application number: PCT/CN2020/106781
(87) International publication number: WO 2022/027222

(57) **Abstract**

Embodiments of this application provide a multi-chip stacked package, a preparation method for a diamond layer having a first conductive channel, a preparation method for a multi-chip stacked package, and an electronic device, and relate to the field of chip package technologies. The multi-chip stacked package includes: a first chip, a second chip, and a diamond layer, where the first chip, the diamond layer, and the second chip are sequentially arranged in a stacked manner; a first conductive channel is provided in the diamond layer, and the first conductive channel runs through the diamond layer along a stacked direction of the first chip, the diamond layer, and the second chip and electrically connects the first chip and the second chip.

## Description

### TECHNICAL FIELD

This application relates to the field of chip package technologies, and in particular, to a multi-chip stacked package, a preparation method for a diamond layer having a first conductive channel, a preparation method for a multi-chip stacked package, and an electronic device.

### BACKGROUND

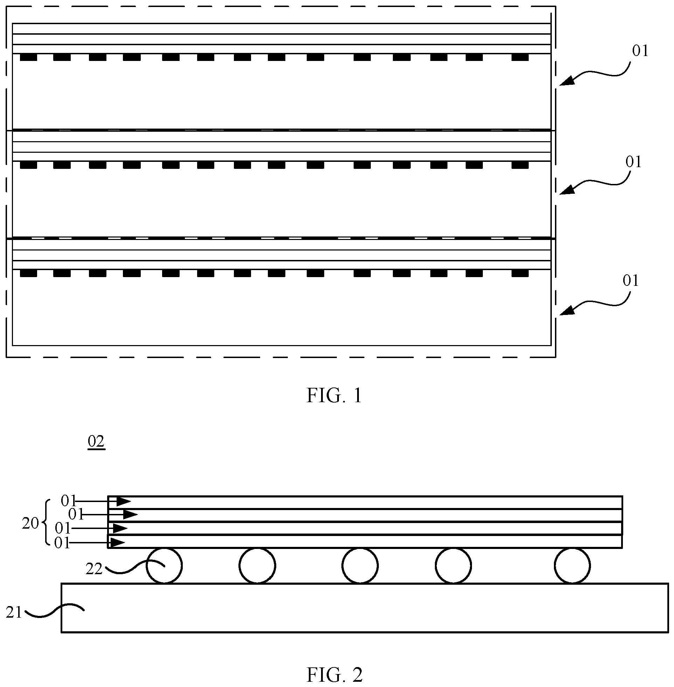

FIG. 1 is a schematic diagram of a structure of a multi-chip stacked package. In the multi-chip stacked package, a plurality of chips 01 having different functions are arranged in a stacked manner, so as to meet requirements of a plurality of users, a high throughput, a low delay, and high density.

Each of the chips 01 includes semiconductor devices, and the semiconductor devices generate heat during operation. In addition, as a quantity of semiconductor devices increases, a heat dissipation problem of multi-chip stacked package becomes particularly prominent. Especially, chips in the middle and the lowermost chip connected to a printed circuit board are prone to local overheating. If heat of high-temperature hot spots of these chips cannot be dissipated in time, performance of the chips is severely affected.

### SUMMARY

Embodiments of this application provide a multi-chip stacked package, a preparation method for a diamond layer having a first conductive channel, a preparation method for a multi-chip stacked package, and an electronic device. A main objective is to provide a diamond layer having a conductive channel disposed between two adjacent chips, where the diamond layer can prevent local overheating of the chips.

To achieve the foregoing objective, the following technical solutions are used in embodiments of this application.

According to a first aspect, this application provides a multi-chip stacked package, including:
a first chip, a second chip, and a diamond layer, where the first chip, the diamond layer, and the second chip are sequentially arranged in a stacked manner; a first conductive channel is provided in the diamond layer, and the first conductive channel runs through the diamond layer along a stacked direction of the first chip, the diamond layer, and the second chip and electrically connects the first chip and the second chip.

According to the multi-chip stacked package provided in embodiments of this application, because the diamond layer is disposed between the first chip and the second chip that are stacked, a temperature equalization effect of the diamond layer is prominent. When a local temperature of either of the first chip and the second chip is excessively high, the diamond layer can quickly cool a high-temperature hot spot, to prevent an excessively high temperature from affecting performance of a semiconductor device. In addition, when the first chip and the second chip are arranged in a stacked manner, circuits between the first chip and the second chip need to be connected. In this case, the first conductive channel is provided in the diamond layer, and the first conductive channel electrically connects the first chip and the second chip, so that the circuits between the first chip and the second chip can be interconnected.

In a possible implementation of the first aspect, the first chip includes a first substrate and a first metal layer, where the first metal layer is disposed on the first substrate; and the second chip includes a second substrate and a second metal layer, where the second metal layer is disposed on the second substrate, where the diamond layer is located between the first metal layer and the second metal layer, and the first conductive channel electrically connects the first metal layer and the second metal layer.

In the multi-chip stacked package, there is a case that the first metal layer of the first chip and the second metal layer of the second chip are arranged opposite to each other. In this way, the first conductive channel provided in the diamond layer can electrically connect the first chip and the second chip.

In a possible implementation of the first aspect, the first chip includes a first substrate and a first metal layer, where the first metal layer is disposed on the first substrate; and the second chip includes a second substrate and a second metal layer, where the second metal layer is disposed on the second substrate, where the diamond layer is located between the first metal layer and the second metal layer, a bump is provided between the diamond layer and the first metal layer and a bump is provided between the diamond layer and the second metal layer, and the first metal layer is electrically connected to the second metal layer through the first conductive channel and the bumps.

In a possible implementation of the first aspect, the first chip includes a first substrate and a first metal layer, where the first metal layer is disposed on the first substrate, and a second conductive channel runs through the first substrate and the first substrate is electrically connected to the first metal layer; and the second chip includes a second substrate and a second metal layer, where the second metal layer is disposed on the second substrate, where the diamond layer is located between the first substrate and the second metal layer, and the first metal layer is electrically connected to the second metal layer through the first conductive channel and the second conductive channel.

In the multi-chip stacked package, there is a case that the first substrate of the first chip and the second metal layer of the second chip are arranged opposite to each other, to electrically connect the first chip and the second chip, the second conductive channel needs to be disposed in the first substrate of the first chip, and then the first conductive channel is electrically connected to the second conductive channel, to electrically connect the first chip and the second chip.

In a possible implementation of the first aspect, the first chip includes the first substrate; and the first metal layer, where the first metal layer is disposed on the first substrate; and the second chip includes: the second substrate; and the second metal layer, where the second metal layer is disposed on the second substrate, where the diamond layer is located between the first metal layer and the second metal layer, a redistribution layer, electrically connected to the second conductive channel is formed on a side surface of the first substrate close to the diamond layer, a bump is provided between both the diamond layer and the redistribution layer, and a bump is provided between the diamond layer and the second metal layer, and the first metal layer is electrically connected to the second metal layer through the first conductive channel, the bumps, the redistribution layer, and the second conductive channel.

In a possible implementation of the first aspect, the first conductive channel includes: a through hole provided in the diamond layer, and an adhesion layer, a diffusion barrier layer, a seed layer, and a conductive material that are disposed on an inner wall surface of the through hole and are sequentially arranged in a laminating manner along a direction away from the inner wall surface of the through hole.

The adhesive layer, the diffusion barrier layer, and the seed layer are included. On one hand, connection strength between the conductive material and the diamond layer can be ensured, and on the other hand, conductive ions in the conductive material can be prevented from diffusing, thereby avoiding reducing conductive performance of the first conductive channel.

In a possible implementation of the first aspect, the multi-chip stacked package further includes a third chip or more chips, a plurality of chips are arranged in a stacked manner, a bonding structure is disposed between every two adjacent chips, and the bonding structure is a diamond layer having a first conductive channel.

In a possible implementation of the first aspect, the first conductive channel includes a through hole provided in the diamond layer, where the through hole is filled with a conductive material, and the through hole including the conductive material is of a solid structure.

According to a second aspect, embodiments of this application further provide a preparation method for a diamond layer having a first conductive channel, where the preparation method includes:
forming a template layer on a substrate; patterning the template layer to form a pattern layer on the substrate; forming a diamond layer on the substrate on which the pattern layer is formed, and forming a first conductive channel running through the diamond layer with assistance of the pattern layer; and removing the substrate to obtain the diamond layer having the first conductive channel.

In the preparation method, the template layer is first formed on the substrate, and the template layer is then patterned. The patterned template layer may be used to assist in forming the first conductive channel. Compared with the prior art in which a through hole is directly provided in a diamond layer to form a first conductive channel, hole opening difficulty is reduced, hole opening efficiency is improved, and roughness of an inner wall surface of the through hole and steepness of the through hole can also be improved, thereby improving conductivity stability of the first conductive channel.

In a possible implementation of the second aspect, the forming a pattern layer on the substrate includes: forming a protrusion on the substrate. The forming a diamond layer on the substrate on which the pattern layer is formed, and forming a first conductive channel running through the diamond layer with assistance of the pattern layer includes: forming the diamond layer on the substrate on which the protrusion is formed, where a surface of the protrusion away from the substrate is exposed out of the diamond layer; removing the protrusion to form a through hole in the diamond layer; and filling the through hole with a conductive material to obtain the first conductive channel, where a surface of the first conductive channel away from the substrate is exposed out of the diamond layer.

That is, the protrusion is first formed on the substrate, and the protrusion is obtained by patterning the template layer, then the diamond layer is prepared on the substrate having the protrusion, and then the protrusion is removed to form the through hole in the diamond layer. Compared with a manner in which the through hole is etched in the diamond layer by using plasma etching or opened by using a laser beam, in this application, the through hole is prepared by removing the protrusion whose material is the same as that of the template layer (the material of the template layer is easy to be patterned, for example, silicon or silicon dioxide). Therefore, according to the preparation method provided in this implementation, the hole opening efficiency can be improved. In addition, the roughness of the inner wall surface of the through hole and the steepness of the through hole can be further improved, thereby improving reliability of an electrical connection of the final first conductive channel.

In a possible implementation of the second aspect, the forming a pattern layer on the substrate includes: forming a through hole in the template layer. The forming a diamond layer on the substrate on which the pattern layer is formed, and forming a first conductive channel running through the diamond layer with assistance of the pattern layer includes: filling the through hole with a conductive material to obtain the first conductive channel, where a surface of the first conductive channel away from the substrate is exposed out of the template layer; removing the template layer; and forming the diamond layer on the substrate on which the first conductive channel is formed, where the surface of the first conductive channel away from the substrate is exposed out of the diamond layer.

In other words, the template layer having the through hole is first formed on the substrate, then metallization processing is performed on the through hole to obtain the first conductive channel, and then the template layer is removed. Compared with a manner in which the through hole is etched in the diamond layer through plasma etching or provided in the diamond layer by using a laser beam, in this application, the through hole is formed on the template layer to prepare the first conductive channel. Therefore, according to the preparation method provided in this implementation, the hole opening efficiency can be improved. In addition, the roughness of the inner wall surface of the through hole and the steepness of the through hole can be further improved, thereby improving the reliability of the electrical connection of the final first conductive channel.

In a possible implementation of the second aspect, a material of the template layer is a silicon-based inorganic material.

The silicon-based inorganic material is easy to be patterned, and can withstand an ambient temperature during diamond layer generation. For example, a material of the template layer is Si, SiO₂, Si₃N₄, or the like.

In a possible implementation of the second aspect, the material of the template layer may alternatively be a metal material or a carbon-based material.

In a possible implementation of the second aspect, after the forming a through hole and before the filling the through hole with a conductive material, the preparation method further includes: arranging an adhesion layer, a diffusion barrier layer, and a seed layer sequentially in a laminating manner on an inner wall surface of the through hole along a direction away from the inner wall surface of the through hole.

The adhesion layer, the diffusion barrier layer, and the seed layer are sequentially prepared on the inner wall surface of the through hole, so as to improve connection strength between the finally formed first conductive channel and the diamond layer, and on the other hand, to prevent conductive ions in the first conductive channel from diffusing, thereby avoiding affecting conductive performance of the first conductive channel.

In a possible implementation of the second aspect, a material of the template layer is a conductive material. The forming a pattern layer on the substrate includes: forming a conductive protrusion on the substrate, where the conductive protrusion forms the first conductive channel; and the forming a diamond layer on the substrate on which the pattern layer is formed includes: forming the diamond layer on the substrate on which the conductive protrusion is formed, where a surface of the first conductive channel away from the substrate is exposed out of the diamond layer.

That is, the template layer is directly made of the conductive material, so that after the template layer is patterned, the protrusion formed on the substrate is made of the conductive material. In this way, the conductive protrusion is directly used as the first conductive channel, and a process of the entire preparation method is simpler.

In a possible implementation of the second aspect, after the forming a template layer on a substrate and before the patterning the template layer, the preparation method further includes: forming a photoresist layer on the template layer; and patterning the photoresist layer.

In a possible implementation of the second aspect, after the forming a template layer on a substrate and before the patterning the template layer, the preparation method further includes: sequentially forming a mask layer and a photoresist layer on the template layer; patterning the photoresist layer; and then patterning the mask layer using the patterned photoresist layer as a mask.

By forming the mask layer, it can be ensured that when the template layer is etched, a pattern formed on the substrate has a good shape, so that the subsequently prepared first conductive channel has a good shape, thereby improving conductive reliability of the first conductive channel.

In a possible implementation of the second aspect, a material of the mask layer is SiO₂, metal, metal oxide, or the like.

In a possible implementation of the second aspect, the forming a diamond layer includes: depositing a diamond seed layer; and generating a diamond on the diamond seed layer.

According to a third aspect, embodiments of this application further provide a preparation method for a multi-chip stacked package, where the preparation method includes:
preparing a diamond layer having a first conductive channel inside by using any implementation of the second aspect; and
sequentially arranging a first chip, the diamond layer, and a second chip in a stacked manner, where the first conductive channel runs through the diamond layer along a stacked direction and electrically connects the first chip and the second chip.

In the multi-chip stacked package prepared by using the preparation method, heat of a high-temperature hot spot of either of the first chip and the second chip can be quickly diffused through the diamond layer, to prevent an excessively high temperature from affecting performance of a semiconductor device.

In addition, the first conductive channel is provided in the diamond layer, and the first conductive channel electrically connects the first chip and the second chip, so that circuits between the first chip and the second chip can be interconnected.

In a possible implementation of the third aspect, the first chip includes: a first substrate and a first metal layer, where the first metal layer is disposed on the first substrate; the second chip includes: a second substrate and a second metal layer, where the second metal layer is disposed on the second substrate; and the sequentially arranging a first chip, the diamond layer, and a second chip in a stacked manner includes: disposing the diamond layer between the first metal layer and the second metal layer, and electrically connecting the first metal layer to the second metal layer through the first conductive channel.

In a possible implementation of the third aspect, the first chip includes: a first substrate and a first metal layer, where the first metal layer is disposed on the first substrate; the second chip includes: a second substrate and a second metal layer, where the second metal layer is disposed on the second substrate, where both the first metal layer and the second metal layer are provided with bumps; and the sequentially arranging a first chip, the diamond layer, and a second chip in a stacked manner includes: disposing the diamond layer between the first metal layer and the second metal layer, and electrically connecting the first conductive channel to the bumps, so that the first metal layer is electrically connected to the second metal layer through the first conductive channel and the bumps.

In a possible implementation of the third aspect, the first chip includes: a first substrate and a first metal layer, where the first metal layer is disposed on the first substrate, and a second conductive channel runs through the first substrate and the first substrate is electrically connected to the first metal layer; the second chip includes: a second substrate and a second metal layer, where the second metal layer is disposed on the second substrate; and the sequentially arranging a first chip, the diamond layer, and a second chip in a stacked manner includes: disposing the diamond layer between the first substrate and the second metal layer, and electrically connecting the first conductive channel to the second conductive channel, so that the first metal layer is electrically connected to the second metal layer.

In a possible implementation of the third aspect, the first chip includes: a first substrate; and a first metal layer, disposed on the first substrate, where a second conductive channel runs through the first substrate and the first substrate is electrically connected to the first metal layer; the second chip includes: a second substrate; and a second metal layer, disposed on the second substrate, where both the first substrate and the second metal layer are provided with bumps; and the sequentially arranging a first chip, the diamond layer, and a second chip in a stacked manner includes: disposing the diamond layer between the first substrate and the second metal layer, and electrically connecting the first conductive channel to the bumps, so that the first metal layer is electrically connected to the second metal layer through the first conductive channel, the bumps, a redistribution layer, and the second conductive channel.

According to a fourth aspect, this application further provides an electronic device, including a printed circuit board and the multi-chip stacked package in any implementation of the first aspect or the multi-chip stacked package prepared in any implementation of the third aspect, where the printed circuit board is electrically connected to the multi-chip stacked package.

The electronic device provided in embodiments of this application includes the multi-chip stacked package prepared in the embodiment of the first aspect or the embodiment of the third aspect. Therefore, the electronic device provided in embodiments of this application and the multi-chip stacked package in the foregoing technical solution can resolve a same technical problem and achieve a same expected effect.

### BRIEF DESCRIPTION OF DRAWINGS

FIG. 1 is a schematic diagram of a structure of a multi-chip stacked package in the prior art;
FIG. 2 is a schematic diagram of a partial structure of an electronic device according to an embodiment of this application;
FIG. 3 is a schematic diagram of a structure of a multi-chip stacked package according to an embodiment of this application;
FIG. 4 is a schematic diagram of a structure of a multi-chip stacked package according to an embodiment of this application;
FIG. 5 is a schematic diagram of a structure of a multi-chip stacked package according to an embodiment of this application;
FIG. 6 is a schematic diagram of a structure of a multi-chip stacked package according to an embodiment of this application;
FIG. 7 is a schematic diagram of a structure of a multi-chip stacked package according to an embodiment of this application;
FIG. 8 is a schematic diagram of a structure of a first conductive channel according to an embodiment of this application;
FIG. 9 is a schematic diagram of a structure reflecting steepness of a through hole;
FIG. 10 is a schematic diagram of a structure reflecting steepness of a through hole;
FIG. 11 is a flow block diagram of a preparation method for a diamond layer having a first conductive channel according to an embodiment of this application;
FIG. 12 is a flow block diagram of a preparation method for a diamond layer having a first conductive channel according to an embodiment of this application;
FIG. 13 is a corresponding schematic diagram of a structure after steps in a preparation method for a diamond layer having a first conductive channel are completed according to an embodiment of this application;
FIG. 14 is a flow block diagram of a preparation method for a diamond layer having a first conductive channel according to an embodiment of this application;
FIG. 15 is a corresponding schematic diagram of a structure after steps in a preparation method for a diamond layer having a first conductive channel are completed according to an embodiment of this application;
FIG. 16 is a flow block diagram of a preparation method for a diamond layer having a first conductive channel according to an embodiment of this application;
FIG. 17 is a corresponding schematic diagram of a structure after steps in a preparation method for a diamond layer having a first conductive channel are completed according to an embodiment of this application;
FIG. 18 is a corresponding schematic diagram of a structure after steps of forming a first conductive channel are completed according to an embodiment of this application;
FIG. 19 is a flow block diagram of a preparation method for a diamond layer having a first conductive channel according to an embodiment of this application; and
FIG. 20 is a corresponding schematic diagram of a structure after steps in a preparation method for a diamond layer having a first conductive channel are completed according to an embodiment of this application.

### Reference numerals:

01-chip; 02-electronic device; 20-multi-chip stacked package; 21-printed circuit board; 22-electrical connection structure; 101-first chip; 102-second chip; 103-third chip; 2-diamond layer; 3-first conductive channel; 4-through hole; 511-first metal layer; 512-first substrate; 521-second metal layer; 522-second substrate; 531-third metal layer; 532-third base; 54-semiconductor device; 55-metal wiring; 6-adhesion layer; 7-diffusion barrier layer; 8-seed layer; 9-substrate; 10-template layer; 11-mask layer; 12-photoresist layer; 13-protrusion; 14-diamond seed layer; 15-second conductive channel; 16-conductive material; 171-first bump; 172-second bump; 173-third bump; 174-fourth bump; 18-redistribution layer; A1-first surface; A2-second surface; P1-axial direction of the through hole; and P2-radial direction of the through hole.

### DESCRIPTION OF EMBODIMENTS

As shown in FIG. 2, an electronic device includes a multi-chip stacked package 20, where the multi-chip stacked package 20 is integrated on a printed circuit board 21, and is electrically connected to the printed circuit board 21 through an electrical connection structure 22. In the multi-chip stacked package 20, a plurality of chips 01 are arranged in a stacked manner, to form a three-dimension (3D) integration manner. In this case, an interconnection manner between the plurality of chips is vertical interconnection, and an interconnected path is short, so that efficiency of signal transmission between the chips can be improved.

The electronic device 02 may include devices such as a mobile phone, a tablet computer (pad), an intelligent wearable product (for example, a smartwatch or a smart band), a virtual reality (VR) terminal device, and an augmented reality (AR) terminal device.

In the foregoing electronic device 02, the electrical connection structure 22 may be a ball grid array (BGA), or may be copper pillar bumps arranged in a plurality of arrays.

With integration of high-density semiconductor devices on the chip, a dense area with a plurality of semiconductor devices is formed on the chip, and the dense area is easy to become a high-temperature hot spot. If heat in the area cannot be rapidly diffused, performance of the semiconductor devices in the area is seriously affected, particularly for the chip in the middle and the chip close to the printed circuit board, a high-temperature hot spot is easier to occur.

A manner of dissipating heat of the multi-chip stacked package may be air cooling, liquid cooling, a heat sink structure, or the like. However, these heat dissipation manners can dissipate only heat of a surface of a chip located at the top in the plurality of chips, and have a poor heat dissipation effect on a chip located in the middle and a chip at the bottom, and cannot effectively cool a local area.

The chip located at the top refers to a chip away from the printed circuit board in the plurality of stacked chips. The chip located at the bottom refers to a chip close to the printed circuit board in the plurality of stacked chips.

The chip may be a wafer, or may be a die obtained after the wafer is cut.

The following describes the multi-chip stacked package 20 in detail.

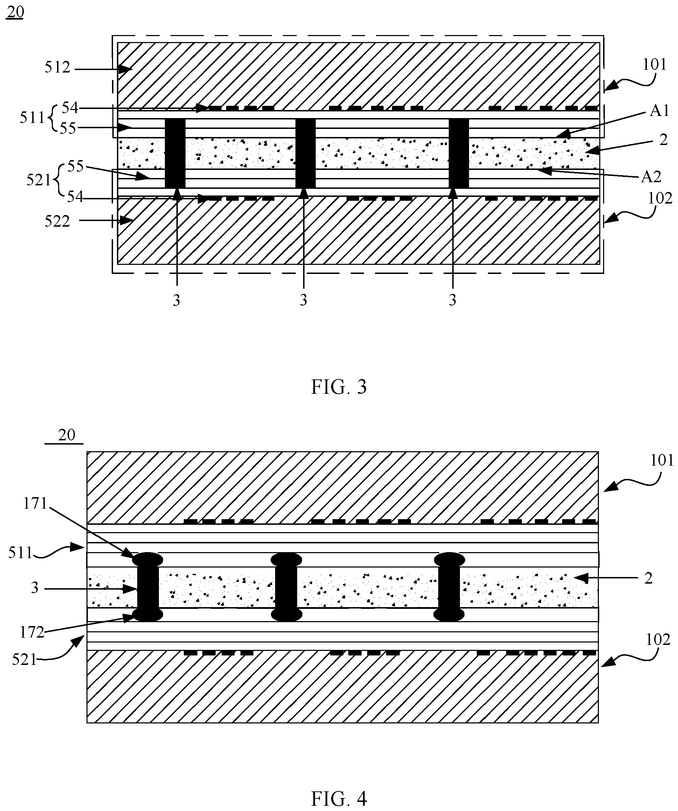

FIG. 3 is a schematic diagram of a structure of a multi-chip stacked package according to an embodiment of this application. The multi-chip stacked package 20 includes a first chip 101 and a second chip 102, where the first chip 101 and the second chip 102 are arranged in a stacked manner, and a diamond layer 2 is disposed between the first chip 101 and the second chip 102. It may be understood in this way that, as shown in FIG. 3, the diamond layer 2 includes a first surface A1 and a second surface A2 that are opposite to each other, where the first surface A1 is bonded to the first chip 101, and the second surface A1 is bonded to the second chip 102, so that the diamond layer 2 is sandwiched between the first chip 101 and the second chip 102.

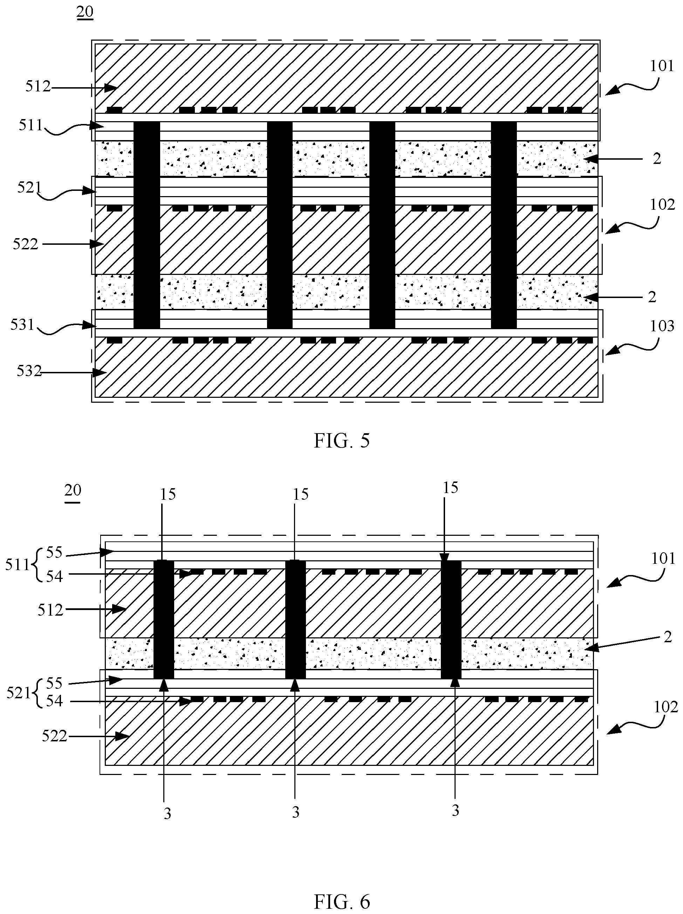

The structure shown in FIG. 3 may be a partial schematic diagram of the multi-chip stacked package according to this embodiment of this application. For example, as shown in FIG. 5, a third chip 103 and a diamond layer 2 located between the second chip 102 and the third chip 103 may be further included. Alternatively, when a chip stacking process can meet a performance requirement of an electronic device, more chips and diamond layers can be stacked.

In this embodiment of this application, any chip may include a substrate and a circuit structure disposed on the substrate, where the circuit structure, in an operation process, may enable the chip to implement a function thereof, for example, a logical operation or data storage.

For example, as shown in FIG. 3, the first chip 101 may include a first substrate 512 and a first metal layer 511, where the first metal layer 511 is disposed on the first substrate 512. Similarly, the second chip 102 may include a second substrate 522 and a second metal layer 521, where the second metal layer 521 is disposed on the second substrate 522. As shown in FIG. 3, the metal layer is a circuit structure configured to form the chip. The metal layer not only includes semiconductor devices 54 manufactured on the substrate, for example, a transistor, but also includes a plurality of layers of metal wirings 55 that are located on a side of the semiconductor devices away from the substrate and that are configured to electrically connect a plurality of semiconductor devices 54 together.

When the semiconductor devices on the chip are operating, a diamond layer has an obvious temperature equalization effect for a dense area with a plurality of semiconductor devices, and can quickly reduce a temperature of the hot spot, thereby reducing a probability of damaging the semiconductor devices. In addition, because thermal conductivity of a diamond can reach 2000 W/mK at normal temperature, compared with silicon with thermal conductivity of 150 W/mK, heat dissipation efficiency is significantly improved.

In the multi-chip stacked package, circuits between chips need to be interconnected. Therefore, referring to FIG. 3, the diamond layer 2 includes a first conductive channel 3, where the first conductive channel 3 runs through the diamond layer 2 along a stacked direction of the first chip 101, the diamond layer 2, and the second chip 102, that is, the first conductive channel 3 runs through the first surface A1 and the second surface A2, and electrically connects the first chip 101 and the second chip 102. Therefore, circuits between two chips are interconnected.

In the multi-chip stacked package provided in this application, there are two cases of stacked manners between two adjacent chips and the diamond layer. One is that metal layers of the two chips are respectively bonded to the diamond layer. The other is that a metal layer of one chip is bonded to the diamond layer, and a substrate of the other chip is bonded to the diamond layer. Therefore, a structure for implementing electrical connection between the first chip and the second chip also has the following two different embodiments.

### Embodiment 1

The first metal layer 511 of the first chip 101 and the second metal layer 521 of the second chip shown in FIG. 3 and FIG. 4 are respectively bonded to the diamond layer 2.

In this structure, an electrical connection structure that electrically connects the first metal layer 511 and the second metal layer 521 has a plurality of implementations. In an optional implementation, with reference to FIG. 3, a redistribution layer (RDL) is arranged on the first metal layer 511, a redistribution layer (RDL) is also arranged on the second metal layer 521. Some redistribution layers are located on surfaces of the metal layers, and some redistribution layers are located in the metal layers. One end of the first conductive channel 3 is electrically connected to the redistribution layer of the first chip 101, and the other end of the first conductive channel 3 is electrically connected to the redistribution layer of the second chip 102, so that the first chip 101 can be electrically connected to the second chip 102, and a circuit on the first chip 101 and a circuit on the second chip 102 can be interconnected. In another optional implementation, with reference to FIG. 4, a first bump 171 is formed between the first metal layer 511 and the diamond layer 2, a second bump 172 is formed between the second metal layer 521 and the diamond layer 2, and the first conductive channel 3 is separately electrically connected to the first bump 171 and the second bump 172, so as to electrically connect the first metal layer 511 and the second metal layer 521. In this way, circuits between the first chip and the second chip can be interconnected.

### Embodiment 2

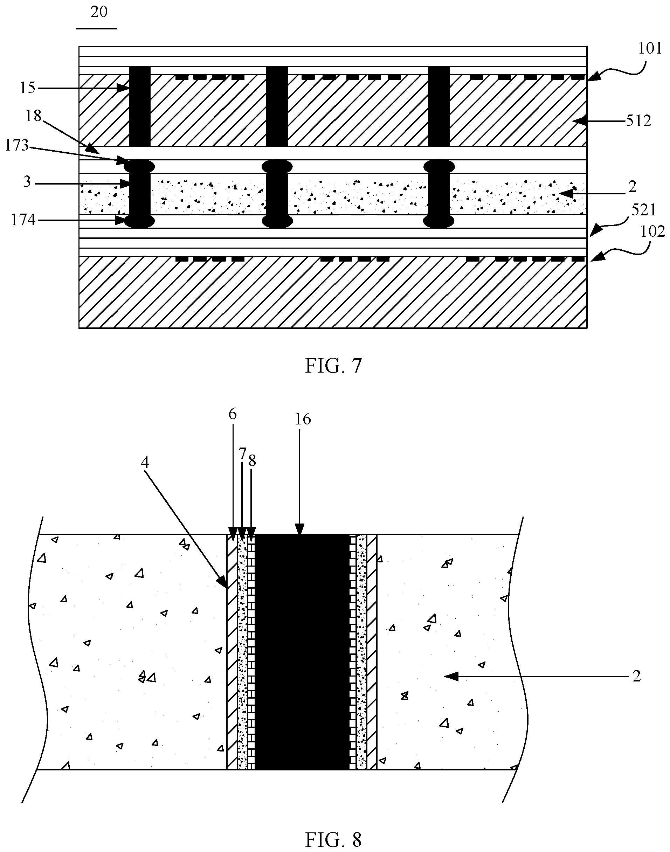

FIG. 6 and FIG. 7 show that the first substrate 512 of the first chip 101 is bonded to the diamond layer 2, and the second metal layer 521 of the second chip is bonded to the diamond layer 2.

In this structure, an electrical connection structure that electrically connects the first metal layer 511 and the second metal layer 521 also has a plurality of implementations. In an optional implementation, with reference to FIG. 6, a second conductive channel 15 is provided in the first substrate 512 of the first chip 101, where the second conductive channel 15 is electrically connected to the redistribution layer in the first metal layer 511 of the first chip 101, the first conductive channel 3 is electrically connected to the redistribution layer in the second metal layer 521 of the second chip 102, and the first conductive channel is electrically connected to the second conductive channel, so as to electrically connect the first chip and the second chip. In another optional implementation, with reference to FIG. 7, in addition to providing the second conductive channel 15 in the first substrate 512 of the first chip 101, a redistribution layer 18 is disposed on the first substrate 512, a third bump 173 is provided between the redistribution layer 18 and the diamond layer 2, and a fourth bump 174 is provided between the diamond layer 2 and the second metal layer, that is, the first metal layer is electrically connected to the second metal layer through the first conductive channel 3, the third bump 173, the fourth bump 174, the redistribution layer 18, and the second conductive channel 15.

In a processing and manufacturing process of the first conductive channel, a through hole may be first formed, and then the through hole is filled with a conductive material, to obtain the first conductive channel.

Referring to FIG. 8, generally, the through hole is filled with the conductive material in a manner of electroplating metal. To better attach the electroplated metal to the through hole when the metal is electroplated, so as to improve conductive reliability of the first conductive channel, a seed layer 8 is disposed between an inner wall surface of a through hole 4 and a conductive material 16, and a material of the seed layer 8 is the same as that of the conductive material 16.

As a usage time of the multi-chip stacked package is prolonged, conductive ions in the conductive material diffuse, and may diffuse into the diamond layer. In this case, as the conductive ions continuously diffuse, conductive performance of the first conductive channel is severely affected.

To prevent diffusion of the conductive ions in the conductive material, referring to FIG. 8, a diffusion barrier layer 7 is disposed between the seed layer 8 and the inner wall surface of the through hole, so that the conductive performance of the first conductive channel does not deteriorate due to the prolonged usage time of the multi-chip stacked package.

When the diffusion barrier layer 7 is disposed, to firmly attach the diffusion barrier layer 7 to the through hole and prevent the diffusion barrier layer 7 from falling off, referring to FIG. 8, an adhesion layer 6 is disposed between the diffusion barrier layer 7 and the inner wall surface of the through hole. That is, the adhesion layer 6 is grown in advance on the inner wall surface of the through hole, and the diffusion barrier layer 7 is then arranged. In this way, the diffusion barrier layer 7 can be firmly attached in the through hole through the adhesion layer 6.

In some implementations, when the conductive material is copper, a silicon dioxide adhesion layer (an oxide adhesion layer), a Ta diffusion barrier layer, or a TaN diffusion barrier layer, and a Cu seed layer are arranged between the through hole and the conductive material in a stacked manner in a direction close to the conductive material.

It should be noted that the conductive material is not limited in this application, and the conductive material includes, but is not limited to, copper. In addition, materials of the adhesion layer, the diffusion barrier layer, and the seed layer are not limited either, provided that the material of the seed layer is the same as the conductive material.

In some implementations, when the through hole is filled with the conductive material, space in the through hole may be fully filled to form a solid structure.

When the diamond layer having the first conductive channel is prepared, a hole is generally drilled in the diamond layer in a laser hole opening manner or a plasma etching manner. The two hole opening manners are analyzed in the following.

Manner 1: A hole is opened by using a laser, that is, a laser beam is used to drill a hole. Disadvantages of the laser hole opening are as follows: A laser beam can form only one through hole at a time, and hole opening efficiency is low. In addition, a shape of the through hole formed after laser beam hole opening is poor.

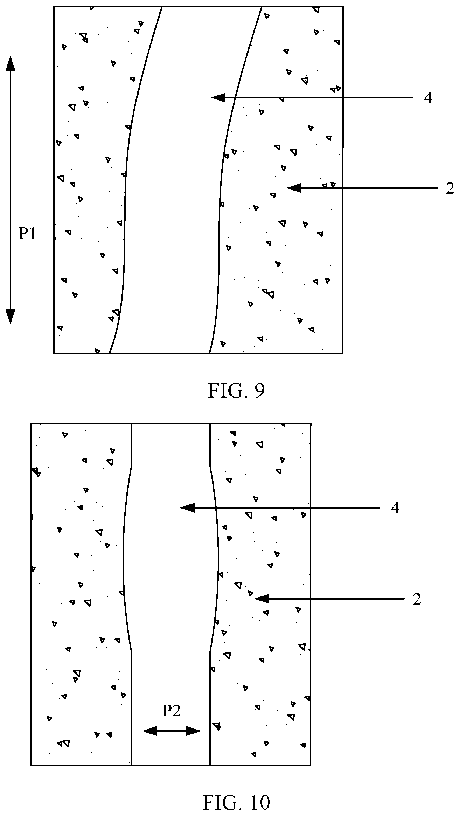

It should be noted that the shape of the through hole includes at least the following two aspects: Roughness of an inner wall surface of the through hole and steepness of the through hole. As shown in FIG. 9 and FIG. 10, the steepness refers to straightness of a through hole 4 in an axial direction (a direction P1 shown in FIG. 9) and evenness of a hole size of the through hole 4 in a radial direction (a direction P2 shown in FIG. 10).

To enable the first conductive channel to have good conductive reliability, a high requirement is imposed on the roughness of the inner wall surface of the through hole and the steepness of the through hole. A reason is as follows: if the roughness of the inner wall surface of the through hole is large, when metallization processing is performed on the through hole, deposition of metal is affected. Consequently, the deposited metal is unevenly distributed, and further, conductivity stability of the first conductive channel is greatly affected. If the steepness of the through hole is poor, as shown in FIG. 9, that is, if the through hole has a large degree of inclination, or as shown in FIG. 10, an inner diameter of the through hole gradually changes along the axial direction, and it is formed that a hole size of a partial segment is large and a hole size of a partial segment is small. When metallization processing is performed on the through hole of the structure, the deposited metal may still be unevenly distributed, and the conductive stability of the first conductive channel is also greatly affected.

Manner 2: Plasma etching is used. Although a plurality of through holes can be etched at a time, when plasma chemically reacts with a diamond, reaction efficiency is extremely low, resulting in low etching efficiency. For example, in a conventional low-temperature plasma reaction cavity, an etching rate of the diamond is 10 um/h to 20 um/h, and an etching time required for a through hole with a depth of 100 um to 1000 um is 5 hours or more, resulting in low efficiency.

Embodiments of this application provide a preparation method for a diamond layer having a first conductive channel inside. On a premise of improving the hole opening efficiency, the roughness of the inner wall surface of the through hole and the steepness of the through hole can be further improved, to improve the conductive performance of the first conductive channel. The diamond layer prepared by using this method may be used between two adjacent chips in a multi-chip stacked package, so as to achieve a temperature equalization effect and prevent a high-temperature hot spot from occurring.

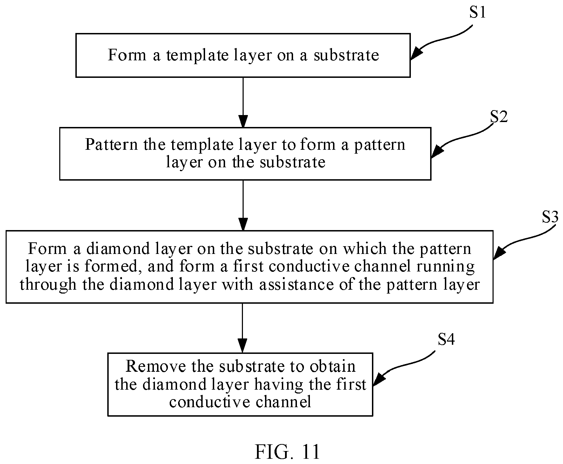

As shown in FIG. 11, the preparation method includes:
Step S1: Form a template layer on a substrate.

A material suitable for diamond growth may be selected as a material of the substrate. For example, Si, SiC, WC, or metal may be selected.

A material that is easy to be patterned and can withstand a diamond generation environment may be selected a material of the template layer. For example, Si, SiO₂, or Si₃N₄ may be selected. A metal material or a carbon-based material may alternatively be selected. The template layer may be formed by using a deposition method.

Step S2: Pattern the template layer to form a pattern layer on the substrate.

Step S3: Form a diamond layer on the substrate on which the pattern layer is formed, and form a first conductive channel running through the diamond layer with assistance of the pattern layer. In this case, a hole is not directly opened on the diamond layer. Therefore, hole opening efficiency is improved.

Step S4: Remove the substrate to obtain the diamond layer having the first conductive channel.

The following refines the foregoing preparation method by using three optional implementations. Certainly, in addition to the three implementations, another implementation may be further included.

### Implementation 1

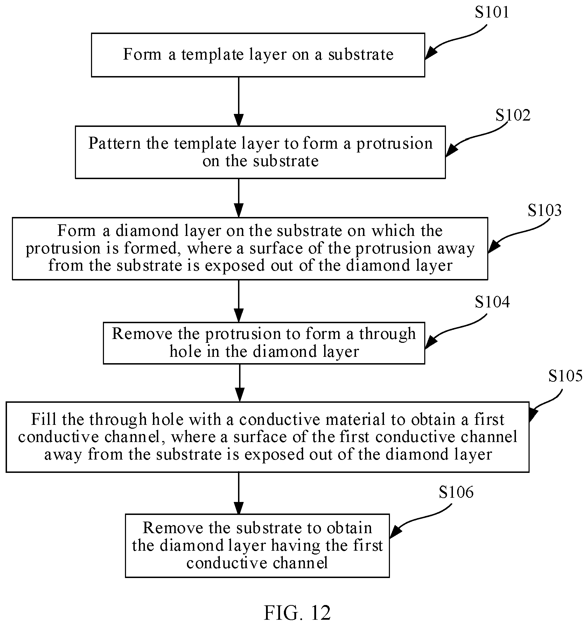

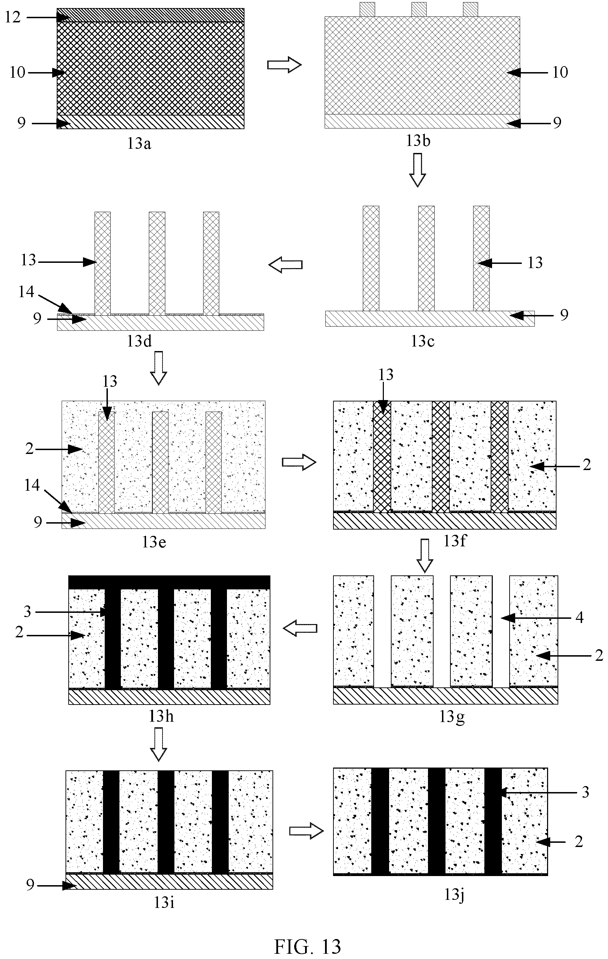

FIG. 12 is a flow block diagram of a preparation method for a diamond layer having a first conductive channel, and FIG. 13 is a corresponding schematic diagram of a structure after steps corresponding to FIG. 12 are completed.

The preparation method includes the following steps:
As shown in step S101 in FIG. 12 and 13a in FIG. 13, a template layer 10 is formed on a substrate 9.

During specific implementation, a thickness size of a template layer needs to be greater than a height size of a final first conductive channel. For example, a difference between the thickness size of the template layer and the height size of the first conductive channel is between 100 µm and 1000 µm, or certainly, may be within another range. An objective of this is to reserve a certain process error for the preparation method, so as to prevent a final axial size of the first conductive channel from not meeting a preset value.

As shown in step S102 in FIG. 12 and 13b and 13c in FIG. 13, the template layer 10 is patterned to form a protrusion 13 on the substrate 9.

Alternatively, a photoresist layer 12 may be formed on the template layer 10. During specific implementation, first, patterning is performed on the photoresist layer 12 through a mask, exposure development, and etching, and a protrusion is etched. The protrusion is a position reserved for the first conductive channel. The protrusion may be of a columnar structure and match a shape of the final columnar first conductive channel, or a radial size of the protrusion of the columnar structure may be greater than a radial size of the first conductive channel by 5 µm to 50 µm, or a difference between a radial size of the protrusion of the columnar structure and a radial size of the first conductive channel may be within another range.

In addition, a quantity of protrusions is equal to a quantity of final first conductive channels. When there are a plurality of protrusions, a spacing between two adjacent protrusions is substantially equal to a spacing between two adjacent final first conductive channels.

After the photoresist layer is patterned, the template layer 10 is patterned using the patterned photoresist layer 12 as a mask to form the protrusion 13 on the template layer.

Because a height size of the formed protrusion 13 is far greater than the radial size, to make an outer wall surface of the formed protrusion smooth and have good steepness, a Bosch etching process may be used.

As shown in step S103 in FIG. 12 and 13d and 13e in FIG. 13, a diamond layer 2 is formed on the substrate 9 on which the protrusion 13 is formed.

In a process of forming the diamond layer 2, the diamond layer 2 is usually prepared by using a deposition method. To evenly generate a deposited diamond, as shown in 13d in FIG. 13, a diamond seed layer 14 may be first deposited on the substrate 9, and an average volume of grains in the diamond seed layer 14 is at a nanometer level.

Generally, when the diamond layer is generated through deposition, the diamond layer is also deposited on a surface of the protrusion 13 away from the substrate. Therefore, as shown in 13e in FIG. 13, before subsequent protrusion removal is performed, the diamond layer needs to be ground and polished to expose the surface of the protrusion, so that the diamond layer is flush with or approximately flush with the surface of the protrusion, and then the protrusion 13 is removed.

As shown in step S104 in FIG. 12 and 13f and 13g in FIG. 13, the protrusion 13 is removed to form a through hole 4 in the diamond layer 2.

When the protrusion 13 is removed, dry etching or wet etching may be used. Whether dry etching or wet etching is selected needs to be determined by a material of the protrusion, that is, a material of the template layer. For example, when the material of the template layer is Si, a KOH or TMAH wet process or a plasma etching process using sulfur hexafluoride (SF₆) may be used. When the material of the template layer is silicon dioxide, a wet process using diluting hydrofluoric acid may be used. When the material of the template layer is silicon nitride, a wet process using hot phosphoric acid may be used.

It should be emphasized that in this step, the protrusion 13 is etched to form the through hole 4 in the diamond layer 2, and etching efficiency of etching the through hole in the protrusion (for example, in a silicon material or a silicon dioxide material) in this application is higher than that of etching a through hole in a diamond layer. Therefore, hole opening efficiency is significantly improved in this application. In addition, roughness and steepness of the through hole formed in this application are smaller and better than that of the hole opened in the diamond layer, because etching the through hole in the silicon material or the silicon dioxide material is less difficult than etching the through hole in a diamond, and quality of the through hole is easily ensured.

As shown in step S105 in FIG. 12 and 13h in FIG. 13, the through hole is filled with a conductive material, to obtain a first conductive channel 3.

A plurality of conductive materials may be selected, for example, Cu, W, TiN, or Al may be selected.

When the conductive material is deposited, physical vapor deposition (PVD), chemical vapor deposition (CVD), electro-chemical deposition (ECD), or the like may be selected.

Generally, when the conductive material is deposited, a surface of the diamond layer is also covered with the conductive material, as shown in 13i of FIG. 13. Therefore, chemical mechanical polishing (CMP) processing needs to be performed on the surface of the diamond layer to remove a redundant conductive material, so that the surface of the diamond layer is exposed and a surface of the first conductive channel is flattened.

As shown in step S106 in FIG. 12 and 13j in FIG. 13, the substrate 9 is removed to obtain the diamond layer 2 having the first conductive channel 3.

It can be learned from the foregoing preparation method that, in this application, the through hole is not directly opened in the diamond layer, but the protrusion is first used to occupy a position of the final first conductive channel, and the through hole can be formed after the protrusion is removed. Compared with a process of opening the through hole in the diamond layer, difficulty of a process of removing the protrusion is greatly reduced, and a shape of the through hole can be further improved, thereby improving reliability of an electrical connection of the first conductive channel.

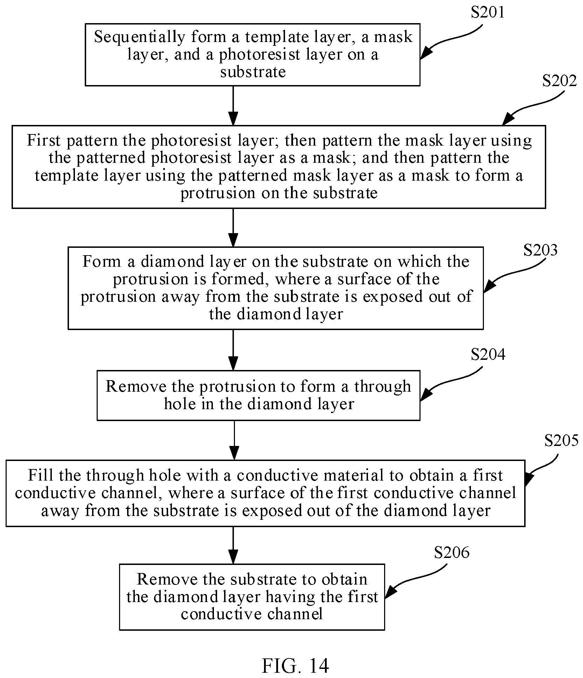

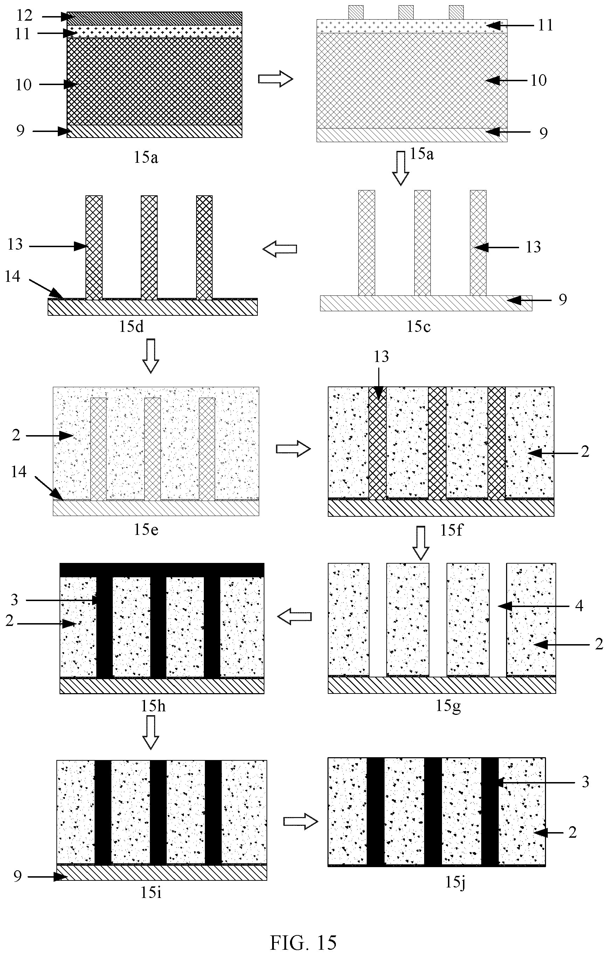

FIG. 14 is also a flow block diagram of a preparation method for a diamond layer having a first conductive channel, and FIG. 15 is a corresponding schematic diagram of a structure after steps corresponding to FIG. 14 are completed.

A difference between FIG. 14 and FIG. 12 is as follows: In step S201 shown in FIG. 14, with reference to 15a in FIG. 15, a template layer 10, a mask layer 11, and a photoresist layer 12 are sequentially formed on a substrate 9.

If a mask layer and a photoresist layer are sequentially formed on a template layer, as shown in step S202, the photoresist layer 12 is first patterned; the mask layer 11 is then patterned using the patterned photoresist layer as a mask; and the template layer 10 is patterned using the patterned mask layer as a mask.

A technical effect generated by disposing the mask layer is as follows: by disposing the mask layer, when the template layer is etched, roughness of an outer surface of an etched protrusion and steepness of the protrusion can be improved. If the roughness and the steepness of the protrusion are improved, the roughness of the inner wall surface of the formed through hole and the steepness of the through hole are also correspondingly improved. When the through hole is metalized, it can be ensured that the metal is evenly deposited in the through hole, thereby finally improving reliability of an electrical connection of the first conductive channel.

For a material of the mask layer, there are a plurality of cases. For example, carbon base, silicon base, metal, or metal oxide may be selected. In conclusion, a higher etching selection ratio of the mask layer to the template layer indicates smaller roughness and smaller steepness of the etched protrusion.

Other steps shown in FIG. 14 are the same as the steps shown in FIG. 12, and details are not described herein again.

### Implementation 2

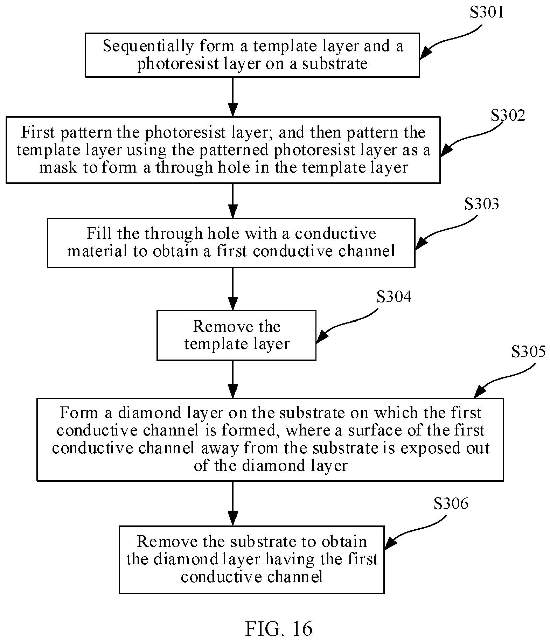

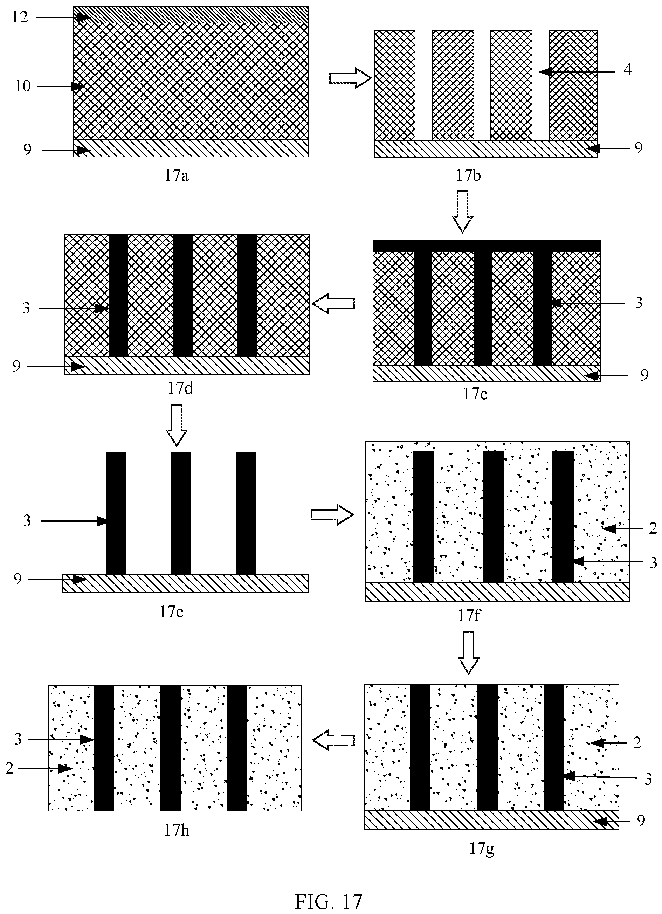

FIG. 16 is a flow block diagram of a preparation method for a diamond layer having a first conductive channel, and FIG. 17 is a corresponding schematic diagram of a structure after steps corresponding to FIG. 16 are completed.

The preparation method includes the following steps:
As shown in step S301 in FIG. 16 and 17a in FIG. 17, a template layer 10 and a photoresist layer 12 are sequentially formed on a substrate 9.

As shown in step S302 in FIG. 16 and 17b in FIG. 17: the photoresist layer 12 is first patterned, and the template layer 10 is then patterned using the patterned photoresist layer 12 as a mask to form a through hole 4 in the template layer 10.

In this step, a first conductive channel is finally formed at a position where the through hole is formed. Therefore, a shape of the through hole can match a shape of the final first conductive channel.

Because the through hole is formed in the template layer in this step, hole opening efficiency of forming the through hole in the template layer (for example, in a silicon material or a silicon carbide material) in this application is higher than that of etching a through hole in a diamond layer. In addition, roughness and steepness of the through hole formed in the template layer in this application are smaller and better than that of a hole opened in a diamond layer, roughness of a surface of the finally formed first conductive channel in contact with the diamond layer is smaller, and an electrical connection of the first conductive channel is more reliable.

As shown in step S303 in FIG. 16 and 17c in FIG. 17, the through hole is filled with a conductive material, to obtain a first conductive channel 3.

Generally, when the conductive material is deposited, a surface of the template layer is also covered with the conductive material, as shown in 17d of FIG. 17. Therefore, chemical mechanical polishing processing needs to be performed on the surface of the template layer to remove a redundant conductive material, so that the surface of the template layer is exposed and a surface of the first conductive channel is flattened.

As shown in step S304 in FIG. 16 and 17e in FIG. 17: the template layer is removed to leave a first conductive channel structure.

As shown in step S305 in FIG. 16 and 17f in FIG. 17, a diamond layer 2 is formed on the substrate 9 on which the first conductive channel 3 is formed.

As shown in step S306 in FIG. 16 and 17h in FIG. 17, the substrate is removed to obtain the diamond layer 2 having the first conductive channel 3.

Generally, when the diamond layer is generated through deposition, a surface of the diamond layer 2 is higher than a surface of the first conductive channel. Therefore, as shown in 17g in FIG. 17, before the substrate is removed, the diamond layer needs to be ground and polished to expose the surface of the first conductive channel, so that the diamond layer is flush with or is approximately flush with the surface of the first conductive channel, and the substrate 9 is then removed.

It can be learned from the foregoing preparation method that, in this application, the through hole is not directly opened in the diamond layer, but the through hole is first formed in the template layer, that is, the through hole is opened in the template layer during hole opening. Compared with opening a through hole in a diamond layer, a process difficulty is effectively reduced, and a shape of the through hole can be further improved, thereby improving reliability of an electrical connection of the first conductive channel.

In addition, to improve the shape of the first conductive channel, in 17a in FIG. 17, the template layer, the mask layer, and the photoresist layer may be sequentially formed on the substrate.

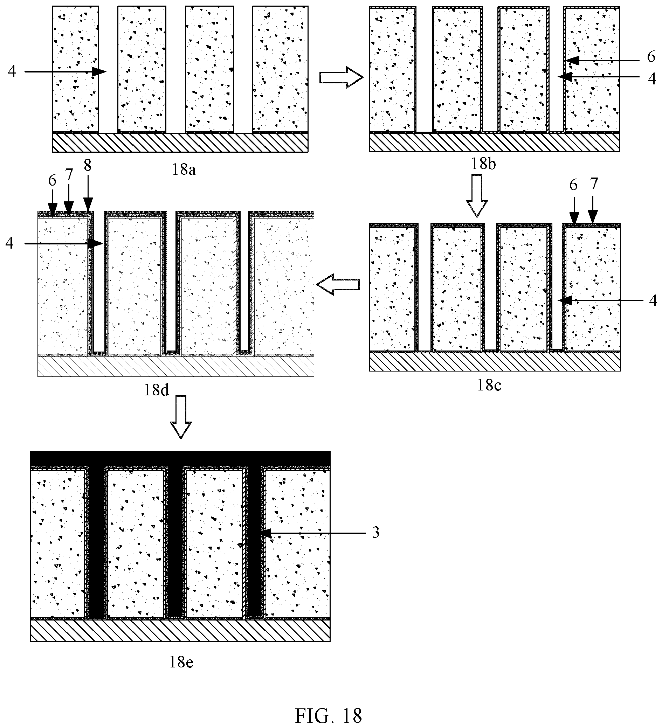

In the foregoing implementation 1 and implementation 2, the filling the through hole with a conductive material specifically includes:
As shown in 18a and 18b in FIG. 18, an adhesion layer 6 is formed on an inner wall surface of a through hole 4.

As shown in 18c in FIG. 18, a diffusion barrier layer 7 is formed on the adhesion layer 6.

As shown in 18d in FIG. 18, a seed layer 8 is formed on the diffusion barrier layer 7.

As shown in 18e in FIG. 18, the conductive material is filled.

### Implementation 3

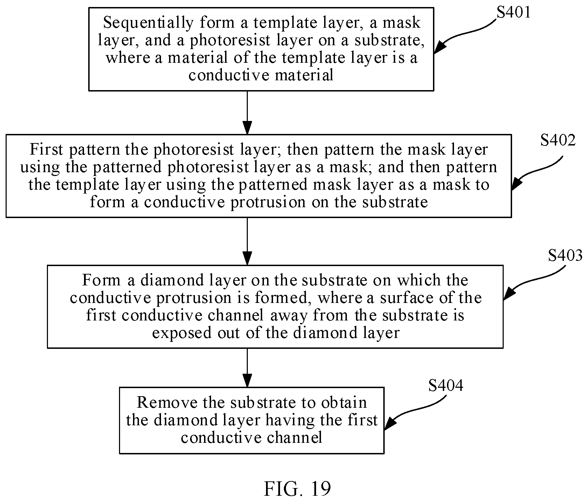

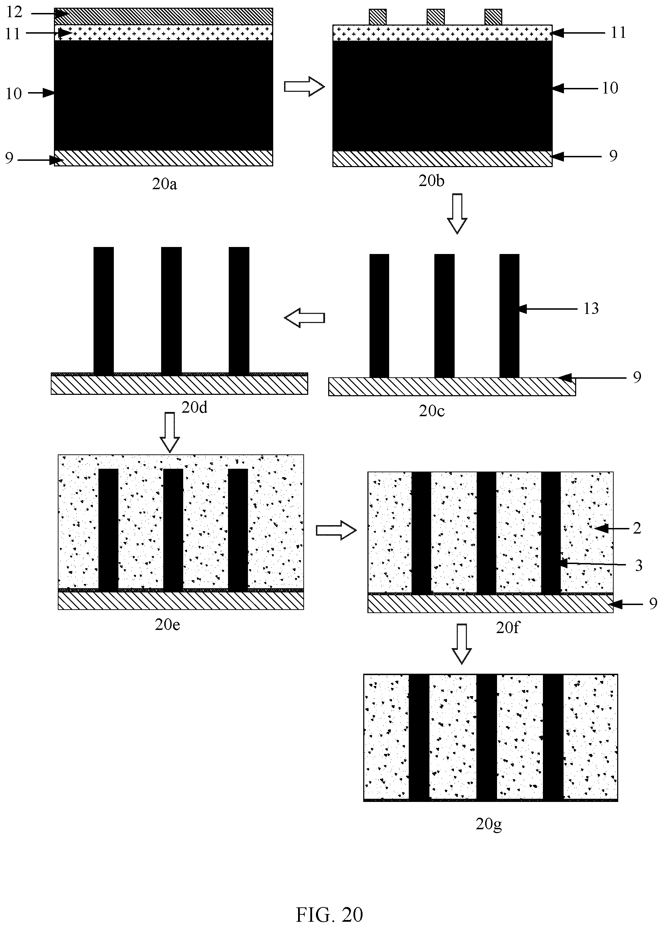

FIG. 19 is a flow block diagram of a preparation method for a diamond layer having a first conductive channel, and FIG. 20 is a corresponding schematic diagram of a structure after steps corresponding to FIG. 19 are completed.

The preparation method includes the following steps:
As shown in step S401 in FIG. 19 and 20a in FIG. 20, a template layer 10, a mask layer 11, and a photoresist layer 12 are sequentially formed on a substrate 9. A material of the template layer is a conductive material.

As shown in step S402 in FIG. 19 and 20b and 20c in FIG. 20, the photoresist layer is first patterned; and the mask layer is then patterned using the patterned photoresist layer as a mask; and the template layer is then patterned using the patterned mask layer as a mask to form a conductive protrusion 13 on the substrate 9, and the conductive protrusion 13 forms a first conductive channel.

In other words, the conductive protrusion obtained through etching may be directly used as the first conductive channel, so that the entire preparation method is simplified.

As shown in step S403 in FIG. 19 and 20d and 20e in FIG. 20, a diamond layer 2 is formed on the substrate 9 on which the conductive protrusion is formed.

As shown in step S404 in FIG. 19 and 20g in FIG. 20, the substrate is removed to obtain the diamond layer 2 having the first conductive channel 3.

Generally, when the diamond layer is generated through deposition, a surface of the diamond layer is higher than a surface of the first conductive channel, as shown in 20f in FIG. 20. Therefore, before the substrate is removed, the diamond layer needs to be ground and polished to expose the surface of the first conductive channel, so that the diamond layer is flush with or is approximately flush with the surface of the first conductive channel, and then the substrate is removed.

It can be learned from the foregoing preparation method that, in this application, the through hole is not directly opened in the diamond layer, but the protrusion is etched on the template layer of the conductive material, and the conductive protrusion is directly used as the first conductive channel. Compared with a process of opening a through hole in a diamond layer, difficulty is greatly reduced.

When the multi-chip stacked package is prepared, the preparation method includes:
preparing a diamond layer having a first conductive channel by using the foregoing preparation method; and
sequentially arranging a first chip, the diamond layer, and a second chip in a stacked manner, where the first conductive channel runs through the diamond layer along a stacked direction and electrically connects the first chip and the second chip.

In the multi-chip stacked package prepared by using the preparation method, a diamond layer is disposed between the first chip and the second chip that are arranged in a stacked manner. Heat dissipated by the first chip and the second chip is conducted onto the diamond layer, and the heat is diffused through the diamond layer with high thermal conductivity. Particularly, the diamond layer has an obvious cooling effect on high-temperature hot spots on the chips, which effectively improves performance of the entire multi-chip stacked package.

In addition, a first conductive channel is formed in the diamond layer and electrically connects the first chip and the second chip, so that circuits between the first chip and the second chip are interconnected.

It should be noted that a thickness size of a generally prepared diamond layer 2 having a first conductive channel 3 is small. For example, a thickness of the diamond layer 2 having the first conductive channel 3 generally ranges from 100 µm to 1000 µm. The diamond layer 2 having the first conductive channel is directly connected to the first chip or the second chip, and an operation process is difficult to control.

To conveniently connect the diamond layer having the first conductive channel to the first chip, before the diamond layer is connected to the first chip, the substrate is not removed, because the substrate can support the diamond layer and facilitate connection to the first chip. After the diamond layer is connected to the first chip, the substrate is removed, and then the diamond layer bonded to the first chip is connected to the second chip.

In an optional implementation, the diamond layer may be disposed between metal layers of the two chips, and the two metal layers are electrically connected through the first conductive channel. In addition, bumps may be arranged on both two metal layers, and then the first conductive channel is electrically connected to the bumps.

In another optional implementation, the diamond layer may be disposed between a metal layer of one chip and a substrate of the other chip of the two chips, and the first conductive channel needs to be electrically connected to a second conductive channel in the substrate. In some implementations, a redistribution layer electrically connected to the second conductive channel may be first arranged on the substrate, a bump is arranged on the redistribution layer, a bump is arranged on the metal layer of the other chip, and the first conductive channel is electrically connected to the bump on the redistribution layer and the bump on the metal layer.

If a multi-chip stacked package with more chips needs to be prepared, stacking may be performed according to either of the foregoing two stacked manners.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A multi-chip stacked package, comprising:
a first chip;
a second chip; and
a diamond layer, wherein the first chip, the diamond layer, and the second chip are sequentially arranged in a stacked manner; and
a first conductive channel is provided in the diamond layer, and the first conductive channel runs through the diamond layer along a stacked direction and electrically connects the first chip and the second chip.

2. The multi-chip stacked package according to claim 1, wherein
the first chip comprises:
a first substrate; and
a first metal layer, disposed on the first substrate; and
the second chip comprises:
a second substrate; and
a second metal layer, disposed on the second substrate, wherein
the diamond layer is located between the first metal layer and the second metal layer, and the first metal layer is electrically connected to the second metal layer through the first conductive channel.

3. The multi-chip stacked package according to claim 1, wherein
the first chip comprises:
a first substrate; and
a first metal layer, disposed on the first substrate; and
the second chip comprises:
a second substrate; and
a second metal layer, disposed on the second substrate, wherein
the diamond layer is located between the first metal layer and the second metal layer, a bump is provided between the diamond layer and the first metal layer and a bump is provided between the diamond layer and the second metal layer, and the first metal layer is electrically connected to the second metal layer through the first conductive channel and the bumps.

4. The multi-chip stacked package according to claim 1, wherein
the first chip comprises:
a first substrate; and
a first metal layer, disposed on the first substrate, wherein a second conductive channel runs through the first substrate and the first substrate is electrically connected to the first metal layer; and
the second chip comprises:
a second substrate; and
a second metal layer, disposed on the second substrate, wherein
the diamond layer is located between the first substrate and the second metal layer, and the first metal layer is electrically connected to the second metal layer through the first conductive channel and the second conductive channel.

5. The multi-chip stacked package according to claim 4, wherein
the first chip comprises:
the first substrate; and
the first metal layer, disposed on the first substrate, wherein the second conductive channel runs through the first substrate and the first substrate is electrically connected to the first metal layer; and
the second chip comprises:
the second substrate; and
the second metal layer, disposed on the second substrate, wherein
the diamond layer is located between the first substrate and the second metal layer, a redistribution layer electrically connected to the second conductive channel is formed on a side surface of the first substrate close to the diamond layer, a bump is provided between the diamond layer and the redistribution layer, and a bump is provided between the diamond layer and the second metal layer, and the first metal layer is electrically connected to the second metal layer through the first conductive channel, the bumps, the redistribution layer, and the second conductive channel.

6. The multi-chip stacked package according to any one of claims 1 to 5, wherein the first conductive channel comprises:
a through hole provided in the diamond layer, wherein the through hole is filled with a conductive material, and the through hole comprising the conductive material is of a solid structure.

7. A preparation method for a diamond layer having a first conductive channel, wherein the preparation method comprises:
forming a template layer on a substrate;
patterning the template layer to form a pattern layer on the substrate;
forming a diamond layer on the substrate on which the pattern layer is formed, and forming a first conductive channel running through the diamond layer with assistance of the pattern layer; and
removing the substrate to obtain the diamond layer having the first conductive channel.

8. The preparation method for a diamond layer having a first conductive channel according to claim 7, wherein
the forming a pattern layer on the substrate comprises: forming a protrusion on the substrate;
the forming a diamond layer on the substrate on which the pattern layer is formed, and forming a first conductive channel running through the diamond layer with assistance of the pattern layer comprises:
forming the diamond layer on the substrate on which the protrusion is formed, wherein a surface of the protrusion away from the substrate is exposed out of the diamond layer;
removing the protrusion to form a through hole in the diamond layer; and
filling the through hole with a conductive material to obtain the first conductive channel, wherein a surface of the first conductive channel away from the substrate is exposed out of the diamond layer.

9. The preparation method for a diamond layer having a first conductive channel according to claim 7, wherein
the forming a pattern layer on the substrate comprises: forming a through hole in the template layer; and
the forming a diamond layer on the substrate on which the pattern layer is formed, and forming a first conductive channel running through the diamond layer with assistance of the pattern layer comprises:
filling the through hole with a conductive material to obtain the first conductive channel, wherein a surface of the first conductive channel away from the substrate is exposed out of the template layer;
removing the template layer; and
forming the diamond layer on the substrate on which the first conductive channel is formed, wherein the surface of the first conductive channel away from the substrate is exposed out of the diamond layer.

10. The preparation method for a diamond layer having a first conductive channel according to claim 8 or 9, wherein after the forming a through hole and before the filling the through hole with a conductive material, the preparation method further comprises:
arranging an adhesion layer, a diffusion barrier layer, and a seed layer sequentially in a laminating manner on an inner wall surface of the through hole along a direction away from the inner wall surface of the through hole.

11. The preparation method for a diamond layer having a first conductive channel according to claim 7, wherein a material of the template layer is a conductive material;
the forming a pattern layer on the substrate comprises: forming a conductive protrusion on the substrate, wherein the conductive protrusion forms the first conductive channel; and
the forming a diamond layer on the substrate on which the pattern layer is formed comprises:
forming the diamond layer on the substrate on which the conductive protrusion is formed, wherein a surface of the first conductive channel away from the substrate is exposed out of the diamond layer.

12. The preparation method for a diamond layer having a first conductive channel according to any one of claims 7 to 11, wherein after the forming a template layer on a substrate and before the patterning the template layer, the preparation method further comprises:
forming a photoresist layer on the template layer; and
patterning the photoresist layer.

13. The preparation method for a diamond layer having a first conductive channel according to any one of claims 7 to 11, wherein
after the forming a template layer on a substrate and before the patterning the template layer, the preparation method further comprises:
sequentially forming a mask layer and a photoresist layer on the template layer;
patterning the photoresist layer; and
then patterning the mask layer using the patterned photoresist layer as a mask.

14. A preparation method for a multi-chip stacked package, comprising:
preparing a diamond layer having a first conductive channel inside by using the preparation method according to any one of claims 7 to 13; and
sequentially arranging a first chip, the diamond layer, and a second chip in a stacked manner, wherein the first conductive channel runs through the diamond layer along a stacked direction, and electrically connects the first chip and the second chip.

15. The preparation method for a multi-chip stacked package according to claim 14, wherein the first chip comprises: a first substrate; and a first metal layer, disposed on the first substrate; the second chip comprises: a second substrate; and a second metal layer, disposed on the second substrate; and
the sequentially arranging a first chip, the diamond layer, and a second chip in a stacked manner comprises:
disposing the diamond layer between the first metal layer and the second metal layer, and electrically connecting the first metal layer to the second metal layer through the first conductive channel.

16. The preparation method for a multi-chip stacked package according to claim 14, wherein the first chip comprises: a first substrate; and a first metal layer, disposed on the first substrate; the second chip comprises: a second substrate; and a second metal layer, disposed on the second substrate, wherein both the first metal layer and the second metal layer are provided with bumps; and
the sequentially arranging a first chip, the diamond layer, and a second chip in a stacked manner comprises:
disposing the diamond layer between the first metal layer and the second metal layer, and electrically connecting the first conductive channel to the bumps, so that the first metal layer is electrically connected to the second metal layer through the first conductive channel and the bumps.

17. The preparation method for a multi-chip stacked package according to claim 14, wherein the first chip comprises: a first substrate; and a first metal layer, disposed on the first substrate, wherein a second conductive channel runs through the first substrate and the first substrate is electrically connected to the first metal layer; the second chip comprises: a second substrate; and a second metal layer, disposed on the second substrate; and
the sequentially arranging a first chip, the diamond layer, and a second chip in a stacked manner comprises:
disposing the diamond layer between the first substrate and the second metal layer, and electrically connecting the first conductive channel to the second conductive channel, so that the first metal layer is electrically connected to the second metal layer through the first conductive channel and the second conductive channel.

18. The preparation method for a multi-chip stacked package according to claim 14, wherein the first chip comprises: a first substrate; and a first metal layer, disposed on the first substrate, wherein a second conductive channel runs through the first substrate and the first substrate is electrically connected to the first metal layer; the second chip comprises: a second substrate; and a second metal layer, disposed on the second substrate, wherein the first substrate has a redistribution layer, and both the redistribution layer and the second metal layer are provided with bumps; and
the sequentially arranging a first chip, the diamond layer, and a second chip in a stacked manner comprises:
disposing the diamond layer between the redistribution layer and the second metal layer, and electrically connecting the first conductive channel to the bumps, so that the first metal layer is electrically connected to the second metal layer through the first conductive channel, the bumps, the redistribution layer, and the second conductive channel.

19. An electronic device, comprising:
a printed circuit board; and
the multi-chip stacked package according to any one of claims 1 to 6, or the multi-chip stacked package prepared according to the preparation method for the multi-chip stacked package according to any one of claims 14 to 18, wherein
the printed circuit board is electrically connected to the multi-chip stacked package.
